# EUROPEAN PATENT APPLICATION

(11) **EP 0 949 678 A1**
(43) Date of publication of application: **13.10.1999**
(21) Application number: 99200475.4
(22) Date of filing: 19.02.1999
(51) Int. Cl.: H01L 23/64, H01L 23/538

(54) **Method for manufacturing an electric circuit for a contactless radiofrequency label, and electric circuit for such label**

(30) Priority: 19.02.1998 NL 1008353
(71) Applicant: N.V. Nederlandsche Apparatenfabriek NEDAP, NL-7141 DE Groenlo (NL)
(72) Inventor: Hogen Esch, Johannes Harm Lukas, 7122 ZN Aalten (NL)
(74) Representative: Ottevangers, Sietse Ulbe

(57) **Abstract**

A coil and connecting construction for a contactless label, wherein the connection between the metal conductor paths and the integrated electronic circuit is formed by sputtering these metal conductor paths over the terminal pads of the integrated circuit. This circuit has been provided on the carrier sheet of the circuit before sputtering. Sputtering can take place via a mask in which the forms of the conductor paths have been left open. The circuit can also be effected by providing the sputtered metal with a resist layer, whereafter the excess metal is etched out. Using this technique, also a connection between the inside and the outside of the coil can be realized over an insulating lacquer mask, which is applied between two sputtering operations.

## Description

The invention relates to a method for manufacturing an electric circuit for a contactless radiofrequency label, wherein in the electric circuit at least one integrated circuit is incorporated and wherein the integrated circuit is provided on a carrier sheet.

The invention further relates to an electric circuit for a contactless radiofrequency label, wherein the electric circuit incorporates at least one integrated circuit, and the integrated circuit is provided on a carrier sheet.

In the production of large quantities of labels which communicate contactlessly using radiofrequency (RF) signal transmission, there exists the problem of connecting the signal transmission coil to the integrated electronic circuit which provides for the communication function. A known method for this purpose is soldering the lead wires of the electromagnetic coil to so-called gold bumps which are provided on the terminal areas, also referred to as terminal pads, of the integrated electronic circuit (IC).

Also, the subject connection is often realized by bonding the IC to a carrier, which consists of a sheet provided with conductor paths. Such bonding can be done in the conventional manner using wire-bonding or by so-called tape automatic bonding (TAB), whereby the IC is soldered directly onto the conductors of the sheet and where the IC is likewise provided with gold bumps.

Depending on the frequency used, a coil consisting of wound and insulated copper or aluminum wire is used, or the coil is directly integrated using the conductor paths on the carrier sheet on which the IC is mounted. This last is typically done if the frequency is in the order of 13.5 MHz. A wound coil is typically used if the frequency is lower than 135 kHz. These frequency regions, because of international rules, are predominantly employed for the above-described contactlessly readable information labels.

The connecting techniques described have as a disadvantage that they require a large number of process steps in the production of the labels, and so are relatively costly.

Accordingly, the method according to the invention is characterized in that over at least one terminal pad of the integrated circuit at least one metal conductor path is sputtered, which, after sputtering, forms part of the electric circuit. Through sputtering, the at least one terminal pad of the integrated circuit can be electrically connected with the rest of the electric circuit in a simple and effective manner.

In particular, it holds that the electric circuit is provided with at least one coil, and the metal conductor path is sputtered also over at least one terminal contact of the coil to effect an electrical connection between the coil and the integrated circuit.

The coil may then consist of a wire-wound coil. This will be the case particularly when the frequency range is lower than 135 kHz.

It is also possible, however, that the coil consists of a metal conductor path provided on the carrier sheet in a manner known per se.

In particular, it holds that the coil is also manufactured by sputtering metal, in this case on the carrier sheet. In particular, it holds in that case that the metal conductor path and the coil are simultaneously manufactured by sputtering metal on the carrier sheet and over the terminal pad. What can then be accomplished is that the metal conductor path provided by sputtering over at least the terminal pad is also provided by sputtering on the carrier to form turns of the coil. Accordingly, in that case, the metal conductor path at the same time forms the turns of the coil and also extends over at least one terminal pad of the integrated circuit, so that the integrated circuit is electrically connected with the coil and thus forms part of the electric circuit.

Accordingly, the present invention meets the problem mentioned by constructing the label such that the coil and the technique of connecting the coil to the IC can be realized in only one or a few process steps.

Because of the small number of turns of the coil that are needed in the frequency range of 13.5 MHz, the method according to the present invention is eminently suitable for this frequency range. For the frequency range lower than 135 kHz, the construction according to the invention can be used to effect the connection between the ends of the wire-wound coil and the integrated circuit indirectly.

The construction of a label according to the invention will be described with reference to a few drawings. In the drawings:
Fig. 1 schematically shows an electric circuit according to the invention;
Fig. 2 schematically shows a connection via openings in the carrier sheet;
Fig. 3 schematically shows a connection over an integrated circuit; and
Fig. 4 shows an alternative embodiment of an electric circuit according to the invention.

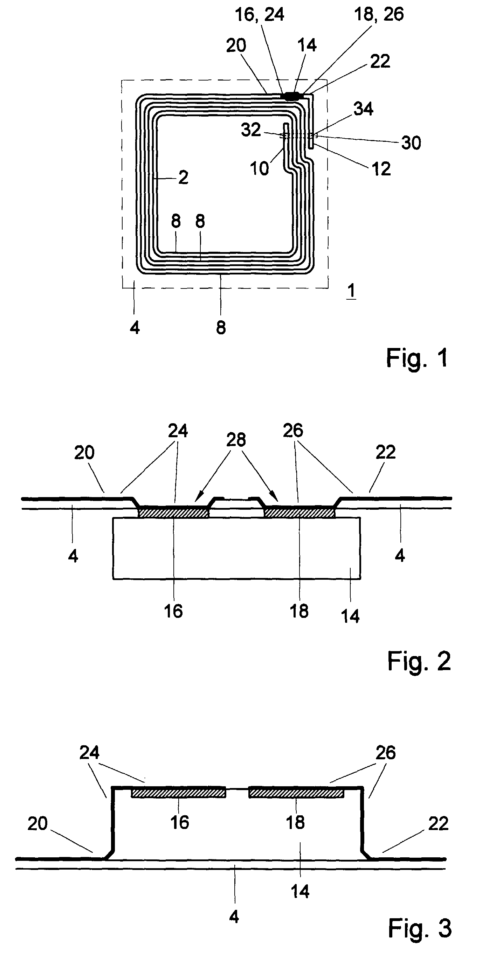

Referring to Fig. 1, a method according to the invention for manufacturing an electric circuit according to the invention will be discussed. The electric circuit 1 according to Fig. 1 comprises a coil 2, which is provided on a carrier sheet 4. The coil 2 comprises turns 8 which are formed by a spiral pattern of conductor paths 8. The conductor paths 8 run from an inside 10 of the coil to an outside 12 of the coil. In this example, the conductor paths 8 of the turns of the coil 2 are provided on the carrier sheet 4 in a manner known per se.

The electric circuit further comprises an integrated circuit 14, known per se, which, in this example, comprises two terminal pads 16 and 18. In Fig. 1, coil leads of the coil 2 are designated by reference numerals 20 and 22.

According to the invention, it holds that the terminal pad 16 is connected with coil lead 20 by sputtering a conductor path 24 over the terminal pad 16, and which also extends over the coil lead 20. Likewise, the terminal pad 18 is connected with the coil lead 22 by sputtering a conductor path 26 which extends over the terminal pad 18 and over the coil lead 22.

Accordingly, it holds that over at least one terminal pad 16, 18 of the integrated circuit 14, a metal conductor path 24, 26 is sputtered, which, after sputtering, forms part of the electric circuit 1 of the label.

According to the invention, it is moreover possible that the turns 8 of the coil are likewise provided by sputtering metal on the carrier 4. In particular, it even holds that the metal conductor paths 24, 26 which connect the coil leads 20, 22 with the terminal pads 16, 18, respectively, and the metal conductor path 8 which forms the turns of the coil, are simultaneously manufactured by sputtering metal on the carrier sheet and over the terminal pad. More particularly, it holds that the metal conductor path provided by sputtering over at least the terminal pad is also provided on the carrier by sputtering to form the turns 8 of the coil. In other words, in that case, in a single sputtering treatment, the metal conductor paths of the coil 8 are formed, as well as the metal conductor paths that extend over the terminal pads 16, 18 of the coil. The metal conductor paths 8, 20, 24, 26 in question in that case form one integrated whole, which has been manufactured in a single sputtering operation.

As indicated in the cross section of Fig. 2, the connection between the conductor paths 24, 26 and the terminal pads 16, 18 of the IC 14 can take place via one or more opening(s) 28 in the sheet 4, so that hardly any roughnesses are present in the surface to be sputtered. It is also possible, as indicated in the cross section of Fig. 3, to sputter the conductor paths 24, 26 over the previously passivated IC 2, whereby electrical contact is made only with the terminal pads 16, 18 of the IC 2. A drawback of this method is that the sputtered conductor paths 24, 26 are provided over the sharp edges of the IC 2 and so are more vulnerable. The advantage, however, is that the sheet does not need to be punched beforehand and that the positioning of the IC 2 is somewhat less critical.

To accomplish that the conductor paths in accordance with the invention are formed upon sputtering, two methods are possible, viz.:
a. Sputtering with the aid of a mask in which the desired conductor paths have been left open and whereby, for each label, via openings in the mask, metal is sputtered on the carrier sheet and on the terminal pads of the priorly placed IC, whereby both the coil and the connections to the IC are formed;
b. Sputtering a metal surface over the entire sheet, including the terminal pads of the priorly placed IC, whereafter the coil and the desired connections are formed by providing a (photo)resist layer and etching out the sputtered metal that is not covered by this resist layer.
Also possible, of course, is a combination of the two above-described process methods.

Naturally, method a. is preferred because of the environmental aspects that apply in the case of etching.

To effect the connection from the inside 10 to the outside 12 of the coil, use can be made of an insulating mask consisting of lacquer or sheet. This insulating mask is applied after the first sputtering operation, in which the above-described conductor paths have been provided. After providing this insulating mask, in a second sputtering operation the desired connection 30 is effected. The connection 30 is provided on the side of the carrier sheet 4 other than the side of the conductor path 8, 20, 22, 24, 26.

To make contact with the inside 10 and the outside 12 of the coil, openings 32 and 34 are provided in the carrier sheet 4.

The type of coil described hereinbefore can be advantageously employed for a frequency region of 3.5 MHz.

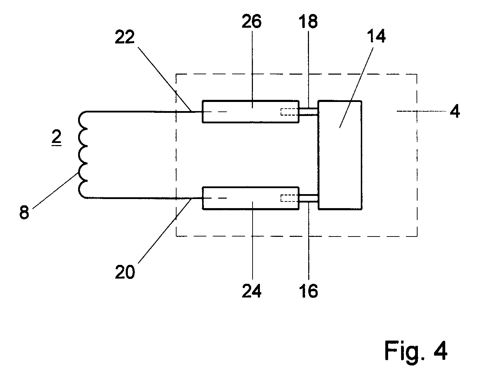

For a frequency region lower than 135 kHz, use can be made of a wire-wound coil, as shown in Fig. 4, where parts corresponding to the preceding figures are provided with the same reference numerals. In the electric circuit according to Fig. 4, again an IC 14 is provided on a carrier sheet 4. In this example, the IC 14 again comprises terminal pads 16, 18. Further, a wire-wound coil 2 with turns 8 has its coil leads 20, 22 provided on the sheet 4. Thereafter, using sputtering, a conductor path 24 has been provided, which extends over the terminal pad 16. The conductor path 24 moreover extends over the coil leads 20. Entirely analogously, by sputtering, a conductor path 26 has been provided, which extends over the terminal pad 18 of the integrated circuit 14. This conductor path 26 moreover extends over the carrier sheet 4, over the coil leads 22. In this example, the turns 8 of the coil are not disposed on the carrier sheet 4. It is also possible, however, that the carrier sheet 4 is so large that these windings 8 are also disposed on the carrier sheet 4. Such a variant is also understood to fall within the scope of the invention.

## Claims

1. A method for manufacturing an electric circuit for a contactless radiofrequency label, wherein in the electric circuit at least one integrated circuit is incorporated and wherein the integrated circuit is provided on a carrier sheet, characterized in that over at least one terminal pad of the integrated circuit at least one metal conductor path is sputtered, which, after sputtering, forms part of the electric circuit.

2. A method according to claim 1, characterized in that the electric circuit is provided with at least one coil, while the metal conductor path is sputtered also over at least one terminal contact of the coil to effect an electrical connection between the coil and the integrated circuit.

3. A method according to claim 1 or 2, characterized in that at least one coil is manufactured by sputtering metal on the carrier sheet.

4. A method according to claim 3, characterized in that the metal conductor path and the coil are simultaneously manufactured by sputtering metal on the carrier sheet and over the terminal pad.

5. A method according to claim 3 or 4, characterized in that the metal conductor path provided by sputtering over at least the terminal pad is also provided by sputtering on the carrier to form turns of the coil.

6. A method according to any one of claims 3-5, characterized in that the position and the dimensions of the conductor path, as well as the position and the dimensions of the connection between the conductor path and the integrated circuit, are determined by sputtering via openings in a mask, which openings correspond to the position and the dimensions of the conductor path to be sputtered.

7. A method according to any one of claims 3-6, characterized in that the position and the dimensions of the conductor path, the coil and the connection between the conductor path and the integrated circuit are determined by sputtering a metal layer over the carrier sheet with the integrated circuit provided thereon, and subsequently providing a resist layer in the form of the desired coil and conductor path, whereafter the excess metal is etched out at those places where no resist layer is provided.

8. A method according to any one of the preceding claims 3-7, characterized in that the electrical connection between an inside and an outside of a spiral pattern, running from the inside to the outside, of a conductor path forming the turns of the coil after a first sputtering operation is realized by providing, after the first sputtering operation, an insulating mask over the turns already formed, and subsequently, in a second sputtering operation, effecting the desired connection between the inside and the outside of the coil over this insulating mask.

9. A method according to any one of the preceding claims, characterized in that the position and the dimensions of the conductor path, as well as the position and the dimensions of the connection between the conductor path and the integrated circuit are determined by sputtering via openings in a mask, which openings correspond to the position and the dimensions of the conductor path to be sputtered.

10. An electric circuit for a contactless radiofrequency label, wherein the electric circuit incorporates at least one integrated circuit, and the integrated circuit is provided on a carrier sheet, characterized in that over at least one terminal pad of the integrated circuit at least one metal conductor path is provided by sputtering, and the conductor path forms part of the electric circuit.

11. An electric circuit according to claim 10, characterized in that the electric circuit comprises at least one coil, while the metal conductor path is sputtered also over at least one terminal contact of the coil and forms an electrical connection between the coil and the integrated circuit.

12. An electric circuit according to claim 10 or 11, characterized in that at least one coil is manufactured by sputtering metal on the carrier sheet.

13. An electric circuit according to claim 12, characterized in that the metal conductor path which extends at least over the terminal pad of the integrated circuit further extends over the carrier sheet and on the carrier sheet forms turns of the coil.
